# FASCICULE DE BREVET EUROPEEN

(11) **EP 2 228 906 B1**
(45) Date de publication et mention de la délivrance du brevet: **29.02.2012**
(21) Numéro de dépôt: 10156246.0
(22) Date de dépôt: 11.03.2010
(51) Int. Cl.: H03K 17/955, H03K 17/96, E05B 65/20

(54) **Procédé de déclenchement d'une action sur un ouvrant de véhicule automobile et dispositif correspondant**
Verfahren zum Auslösen einer Aktion an einem Öffnungselement eines Kraftfahrzeugs und entsprechende Vorrichtung
Method for triggering an action on an automobile door and corresponding device

(30) Priorité: 13.03.2009 FR 0901191
(43) Date de publication de la demande: 15.09.2010
(73) Titulaire: Valeo Sécurité Habitacle, 94046 Créteil Cedex (FR)
(72) Inventeur: Ménard, Eric, 94042 Créteil (FR); Musat, Ciprian, 94042 Créteil (FR)
(74) Mandataire: Jacquot, Ludovic R. G.

(56) Documents cités:
- EP-A- 1 505 734
- DE-A1- 19 620 059
- US-A1- 2003 067 451

## Description

L'invention concerne un procédé de déclenchement d'une action sur un ouvrant de véhicule automobile. L'invention concerne encore un dispositif correspondant pour la mise en oeuvre d'un tel procédé.

L'invention trouve une application particulièrement avantageuse pour le verrouillage et/ou le déverrouillage de l'ouvrant.

Il est connu d'utiliser un dispositif de déclenchement du verrouillage et/ou du déverrouillage d'un ouvrant de véhicule automobile comprenant un capteur capacitif pour détecter un membre d'un utilisateur du véhicule automobile, tel qu'un doigt de l'utilisateur.

Le capteur capacitif est relié à une unité de traitement qui déclenche le verrouillage ou le déverrouillage de l'ouvrant en fonction de l'information délivrée par le capteur capacitif.

Cependant, dans certains cas de fonctionnement, il est possible que la projection d'une masse d'eau sur l'ouvrant, par exemple lors d'un lavage du véhicule ou lors d'une averse de pluie, déclenche le verrouillage ou le déverrouillage de l'ouvrant de manière intempestive.

Le document DE 19620059 A1 divulgue un circuit de déclenchement d'une action sur un ouvrant de véhicule automobile comportant un capteur capacitif et un moyen de traitement adapter pour détecter une variation de capacité en fonction du temps, calculer une tension caractéristique de ladite variation détectée, comparer la tension caractéristique calculé avec une tension de référence et identifier une commande de déverrouillage d'une serrure en fonction des résultats de la comparaison.

L'invention a donc pour objectif de pallier cet inconvénient de l'art antérieur en proposant un procédé et un dispositif correspondant améliorés, permettant de reconnaître de façon fiable une commande volontaire d'un utilisateur.

À cet effet, l'invention a pour objet un procédé de déclenchement d'une action sur un ouvrant, notamment de véhicule automobile, caractérisé en ce que ledit procédé comporte les étapes suivantes :
- on détecte une variation de capacité en fonction du temps sur une surface de détection dudit ouvrant et on délivre un signal de sortie représentatif de ladite variation détectée,
- on décompose le signal de sortie en une pluralité de portions élémentaires de signal sur des périodes de temps prédéfinies,
- pour chaque portion élémentaire de signal, on calcule un paramètre caractéristique de ladite variation détectée,
- on compare lesdits paramètres caractéristiques calculés avec des paramètres de référence correspondants d'un nombre prédéterminé de modèles mémorisés,
- on authentifie une commande d'un utilisateur dudit véhicule pour déclencher une action associée sur l'ouvrant en fonction des résultats de la comparaison, et
- on déclenche une action associée sur l'ouvrant lorsqu'une commande dudit utilisateur est authentifiée.

Un tel procédé permet donc de différencier une main de l'utilisateur sur la surface de détection, de tout autre corps, même ayant des caractéristiques très proches comme une masse d'eau, susceptible de faire varier la capacité de la surface de détection. Ceci assure une sécurité importante dans le véhicule car l'action est déclenchée uniquement lorsqu'une main de l'utilisateur est clairement détectée.

Ledit procédé peut en outre comporter une ou plusieurs caractéristiques suivantes, prises séparément ou en combinaison :
- l'action déclenchée est le verrouillage ou le déverrouillage de l'ouvrant,
- une courbe représentative dudit signal de sortie présente une forme sensiblement en U, et on décompose ledit signal de sortie en au moins sept portions élémentaires de signal, dont:
   - la première portion correspond au début de ladite courbe représentative,
   - la seconde portion correspond à la première pente de ladite courbe représentative,
   - la troisième portion correspond à une portion intermédiaire entre la fin de ladite première pente et un début de seuil d'extrémité de ladite courbe représentative,
   - la quatrième portion correspond audit seuil d'extrémité,
   - la cinquième portion correspond à une portion intermédiaire entre la fin dudit seuil d'extrémité et un début d'une seconde pente de ladite courbe représentative,
   - la sixième portion correspond à ladite seconde pente, et
   - la septième portion correspond à la fin de ladite courbe représentative.
- lesdits paramètres caractéristiques comportent au moins un des paramètres suivants : la vitesse de la variation, la monotonie de la variation, un seuil d'extrémité atteint, la durée du signal de sortie à un même seuil.
- au moins un desdits paramètres caractéristiques correspond à une donnée spécifique de ladite courbe représentative, tel que le rayon de courbure, la pente, l'aspect lisse d'au moins une portion de ladite courbe sur une période de temps prédéfinie,
- l'étape d'authentification d'une commande dudit utilisateur comporte les sous-étapes suivantes :
   - pour chaque paramètre caractéristique calculé, on identifie le paramètre de référence correspondant sensiblement équivalent audit paramètre caractéristique calculé,
   - on détecte si un modèle mémorisé comporte une majorité de paramètres de référence identifiés comme étant sensiblement équivalents auxdits paramètres caractéristiques calculés correspondants, et
   - on vérifie si le modèle détecté se réfère à une commande dudit utilisateur,
- ledit procédé comprend une étape dans laquelle on vérifie si un nombre prédéterminé de paramètres caractéristiques sont sensiblement équivalents aux paramètres de référence d'un même modèle M, et si oui on interrompt la comparaison desdits paramètres caractéristiques calculés avec lesdits paramètres de référence, et
- le nombre prédéterminé de paramètres caractéristique comporte au moins un paramètre caractéristique prédéfini.

L'invention concerne encore un dispositif de déclenchement d'une action sur un ouvrant, notamment de véhicule automobile pour la mise en oeuvre d'un tel procédé, ledit dispositif comportant un capteur capacitif sur une surface de détection dudit ouvrant pour détecter une variation de capacité sur ladite surface, caractérisé en ce que ledit dispositif comporte en outre :
- au moins une bibliothèque dans laquelle est mémorisé un nombre prédéterminé de modèles,
- au moins un moyen de traitement pour :
   - détecter une variation de capacité en fonction du temps sur une surface de détection dudit ouvrant, et délivrer un signal de sortie représentatif de ladite variation détectée,
   - décomposer le signal de sortie en une pluralité de portions élémentaires de signal sur des périodes de temps prédéfinies,
   - pour chaque portion élémentaire de signal, calculer un paramètre caractéristique de ladite variation détectée,
   - comparer lesdits paramètres caractéristiques calculés avec des paramètres de référence correspondants d'un nombre prédéterminé de modèles mémorisés,
   - authentifier une commande d'un utilisateur dudit véhicule pour déclencher une action associée sur l'ouvrant en fonction des résultats de la comparaison, et
   - déclencher une action associée sur l'ouvrant lorsqu'une commande dudit utilisateur est authentifiée.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 représente schématiquement un dispositif pour la mise en oeuvre d'un procédé selon l'invention,
- la figure 2 illustre les différentes étapes du procédé selon l'invention,
- la figure 3 illustre la courbe représentative d'un premier exemple de signal de sortie de détection d'une variation de capacité en fonction du temps,
- la figure 4 illustre la courbe représentative d'un second exemple de signal de sortie de détection d'une variation de capacité en fonction du temps,
- la figure 5 représente un exemple de décomposition en portions élémentaires d'un signal de sortie de détection d'une variation de capacité en fonction du temps,
- la figure 6 représente schématiquement une bibliothèque du dispositif de la figure 1,
- la figure 7 illustre les sous-étapes de l'étape d'authentification du procédé,
- la figure 8a est un tableau explicatif d'un premier exemple pour l'étape de détection d'un modèle ressemblant à la variation de capacité détectée, et
- la figure 8b est un tableau explicatif d'un second exemple pour l'étape de détection d'un modèle ressemblant à la variation de capacité détectée.

L'invention concerne un procédé de déclenchement d'une action, comme le verrouillage ou le déverrouillage, sur un ouvrant (non représenté), par exemple une porte, de véhicule automobile.

À cet effet, l'ouvrant présente une surface de détection comportant une ou plusieurs zones de détection, sur laquelle un utilisateur peut par exemple passer un doigt pour commander le déclenchement d'une action associée sur l'ouvrant.

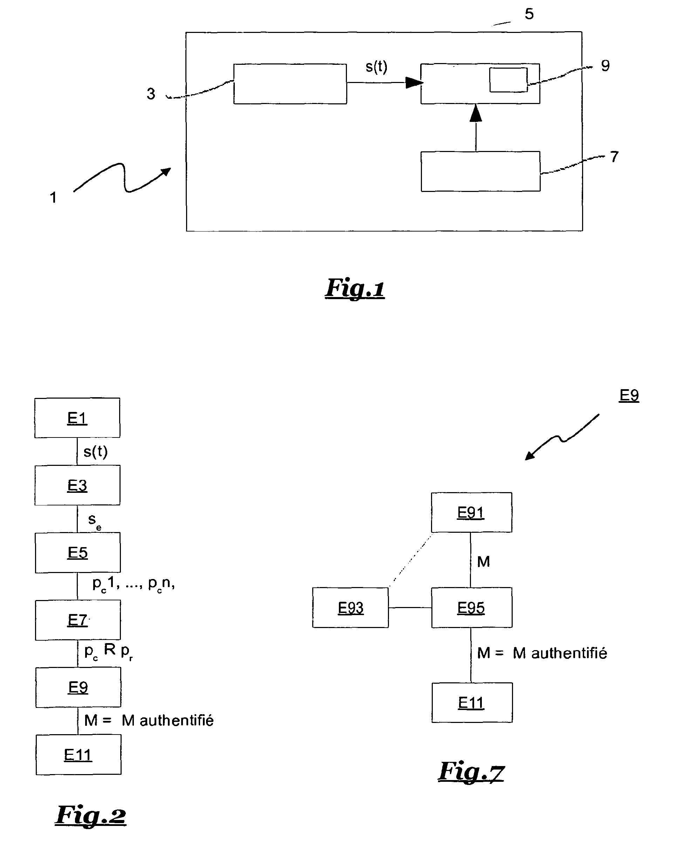

La figure 1 illustre de façon schématique un dispositif 1 de déclenchement pour la mise en oeuvre d'un tel procédé qui peut être situé au niveau de la poignée de l'ouvrant.

Ce dispositif 1 comporte une unité de détection 3 pour détecter lors d'une première étape E1 (voir figure 2), une variation de capacité en fonction du temps sur la surface de détection.

Selon un exemple de réalisation (non représenté), l'unité de détection 3 comporte un capteur capacitif avec un circuit imprimé pouvant être intégré à l'intérieur de la poignée, et une pluralité d'électrodes de détection disposées sur la surface de détection. Grâce au circuit imprimé, le capteur capacitif peut détecter une variation de capacité dans les électrodes.

Un tel capteur capacitif peut être un capteur tactile pour détecter un contact sur la surface de détection ou encore un capteur de proximité pour détecter, par exemple une main ou une masse d'eau, approchant la surface de détection.

Une fois la variation de capacité détectée, l'unité de détection 3 délivre un signal de sortie s(t) représentatif de la variation de capacité détectée en fonction du temps, à destination d'une unité de traitement 5 du dispositif 1.

Cette unité de traitement 5 comporte au moins un moyen de traitement pour traiter le signal de sortie s(t) selon les étapes du procédé et déclencher une action sur l'ouvrant en fonction de ce signal de sortie s(t).

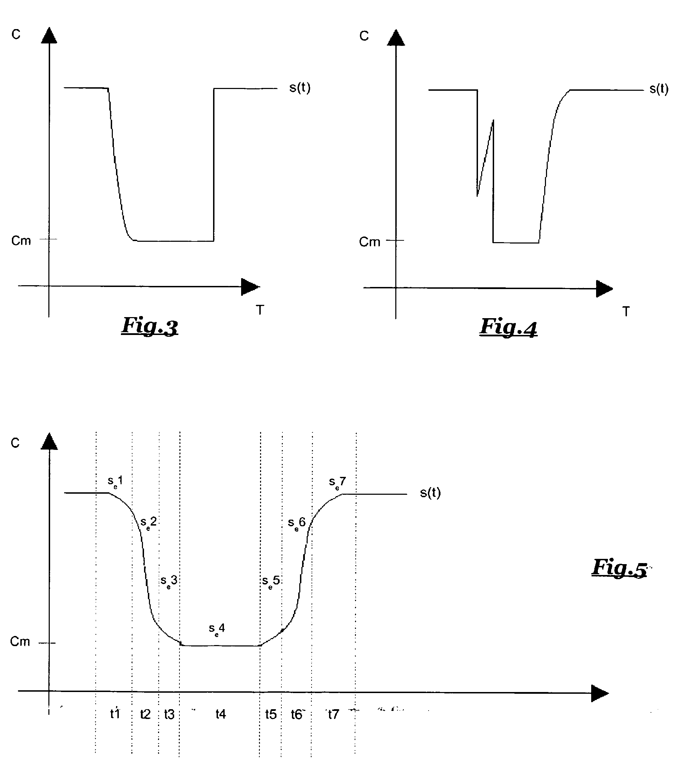

On a représenté sur les figures 3 et 4, deux exemples de courbes représentatives du signal de sortie s(t) de l'unité de détection 3 avec en abscisse le temps et en ordonnée la capacité. Ces courbes illustrent l'évolution de la variation de la capacité de la surface de détection en fonction du temps lorsque cette variation de capacité est provoquée respectivement par la main ou un doigt de l'utilisateur (figure 3) et par une masse d'eau (figure 4).

À l'étape E3 (figure 2), on décompose le signal de sortie s(t) délivré en une pluralité de portions élémentaires de signal sₑ sur des périodes de temps prédéfinies.

Selon un exemple de réalisation illustré sur la figure 5, la courbe représentative du signal de sortie présente une forme sensiblement en U. Dans ce cas, on a choisi de décomposer le signal de sortie s(t) en sept portions élémentaires de signal sₑ1 1 à sₑ7 sur des périodes de temps prédéfinies associées t1 à t7. Selon cette décomposition :
- la première portion sₑ1 correspond au début de la courbe représentative,
- la seconde portion sₑ2 correspond à la première pente de la courbe représentative,
- la troisième portion sₑ3 correspond à une portion intermédiaire entre la fin de la première- pente et un début de seuil d'extrémité de la courbe représentative,
- la quatrième portion sₑ4 correspond au seuil d'extrémité, en fonction de la technologie utilisée,
- la cinquième portion sₑ5 correspond à une portion intermédiaire entre la fin du seuil d'extrémité et un début d'une seconde pente de la courbe représentative,
- la sixième portion sₑ6 correspond à la seconde pente, et
- la septième portion sₑ7 correspond à la fin de la courbe représentative.

De plus, on remarque que dans cet exemple, on détecte une baisse de capacité suivie d'une montée de capacité, de sorte que la première pente de la courbe est négative, le seuil d'extrémité est minimal Cm, et la seconde pente est positive.

Bien entendu, selon la technologie capacitive utilisée, la forme de la courbe représentative du signal de sortie peut être sensiblement en U inversé. Dans ce cas, on détecte une montée de capacité suivie d'une baisse de capacité, de sorte que la première pente de la courbe est positive, le seuil d'extrémité est maximal et la seconde pente est négative.

Avec une telle décomposition en un nombre limité de portions élémentaires de signal sₑ, ici sept, les étapes de décomposition du signal de sortie s(t) et de calcul les paramètres caractéristiques p_{c} associés aux portions élémentaires de signal, peuvent être mises en oeuvre par des moyens de traitement simplifiés, et par conséquent peu coûteux.

Une fois le signal de sortie s(t) ainsi décomposé, on calcule lors d'une étape E5 (figure 2), un ou plusieurs paramètres caractéristiques p_{c} pour chaque portion élémentaire de signal sₑ. Ces paramètres caractéristiques p_{c} peuvent être la vitesse de la variation, la monotonie de la variation, le seuil d'extrémité atteint, la durée du signal de sortie à un même seuil.

Plus précisément, ces paramètres caractéristiques p_{c} correspondent à une donnée spécifique de la courbe représentative, tel que le rayon de courbure, la pente, l'aspect lisse ou encore bruité d'au moins une portion de ladite courbe sur une période de temps prédéfinie.

Dans l'exemple illustré à la figure 5, les paramètres caractéristiques p_{c} calculés à l'étape E5 correspondent :
- pour sₑ1, sₑ3, sₑ5 et sₑ7, au rayon de courbure ainsi qu'à l'aspect lisse ou non de la courbe respectivement sur les périodes de temps t1, t3, t5 et t7,
- pour sₑ2 et sₑ6, à la pente ainsi qu'à la monotonie de la courbe, et
- pour sₑ4, au seuil de variation ainsi qu'à la durée du seuil.

Comme on le constate sur les figures 3 et 4, ces données spécifiques associées aux portions élémentaires de signal sₑ diffèrent entre les deux courbes illustrées. Ainsi, bien que ces deux courbes répondent à un même scénario dans lequel on détecte une baisse de la capacité jusqu'à atteindre un seuil minimal Cm sensiblement équivalent pour les deux courbes, suivie d'une montée de la capacité, il apparaît très clairement sur ces figures, que les données des courbes associées aux portions élémentaires de signal sₑ permettent de distinguer les deux signaux de sortie.

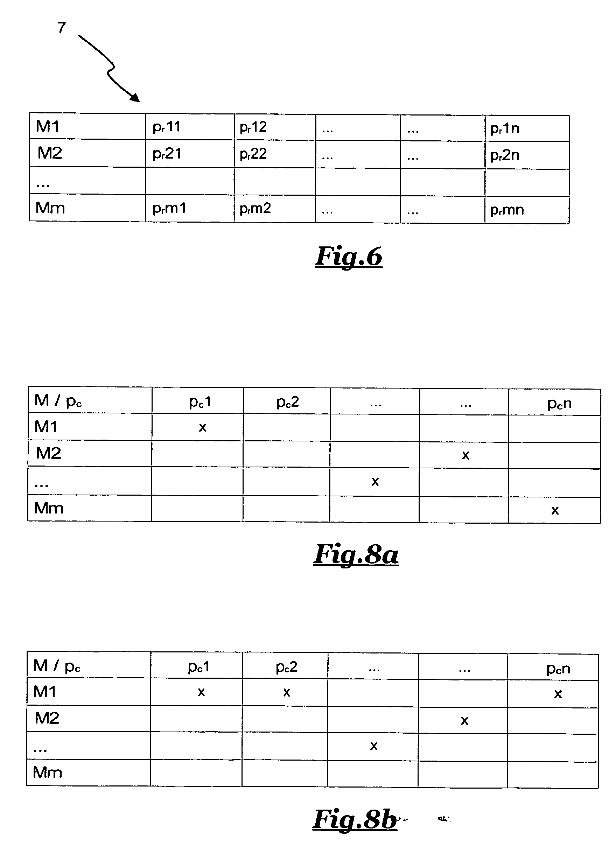

En se référant à nouveau à la figure 2, après avoir calculé une pluralité de paramètres caractéristiques p_{c}1 à p_{c}n à l'étape E5, on compare, lors d'une étape E7, ces paramètres caractéristiques calculés p_{c} avec des paramètres de référence pᵣ correspondants, mémorisés par exemple dans une bibliothèque 7 du dispositif 1 (voir figures 1 et 6).

À cet effet, l'unité de traitement 5 peut comporter une mémoire temporaire 9 pour stocker les paramètres caractéristiques calculés p_{c}1 à p_{c}n le temps nécessaire.

En outre, on prévoit un nombre prédéterminé m de modèles M mémorisés par exemple dans la bibliothèque 7. Chaque modèle M1 à Mm :
- se réfère à un stimulus susceptible de faire varier la capacité de la surface de la détection, tel que le contact ou l'approche de la main de l'utilisateur ou d'une masse d'eau, dont les courbes représentatives sont illustrées sur les figures 3 et 4, et
- comporte- un ensemble de n paramètres de référence pᵣ correspondants respectivement aux paramètres caractéristiques p_{c}1 à p_{c}n.

Les paramètres caractéristiques calculés pₑ sont donc respectivement comparés aux paramètres de référence pᵣ correspondants de chaque modèle M. En pratique, p_{c}1 est comparé successivement à pᵣ11 ,pᵣ21, ..., pᵣm1. De façon analogue, les paramètres suivants p_{c}2 à p_{c}n sont comparés respectivement aux paramètres de référence pᵣ12,... pᵣm2 à pᵣ1n,.... pᵣmn.

Par la suite, on authentifie à l'étape E9 (figure 2) une commande d'un utilisateur pour déclencher une action associée sur l'ouvrant en fonction des résultats de la comparaison.

Pour ce faire, pour chaque paramètre caractéristique calculé p_{c}, on détermine lors d'une étape E91 (figure 7), à quel modèle M il ressemble le plus, c'est-à-dire quel modèle M comporte le paramètre de référence pᵣ correspondant sensiblement équivalent au paramètre caractéristique calculé p_{c}.

Puis, on identifie à quel modèle M le signal de sortie s(t) ressemble le plus. Plus précisément, on détecte le modèle M qui comporte une majorité de paramètres de référence pᵣ sensiblement équivalents aux paramètres caractéristiques calculés p_{c} correspondants.

On a schématisé cette étape sur les figures 8a et 8b, à l'aide d'un tableau dans lequel pour chaque paramètre caractéristique p_{c}1 à p_{c}n, on coche la case du modèle M auquel il ressemble.

Lorsque le signal de sortie s(t) ne ressemble majoritairement à aucun modèle, on inhibe la transmission d'un signal de déclenchement d'une action sur l'ouvrant, c'est l'étape E93 (figure 7).

Au contraire, lorsque le signal de sortie s(t) ressemble, majoritairement à un modèle détecté, on vérifie à l'étape E95 si ce modèle détecté se réfère à une commande de l'utilisateur. Si oui, on autorise la transmission d'un signal de déclenchement d'une action sur l'ouvrant à l'étape E11. Sinon, on inhibe la transmission d'un signal de déclenchement d'une action sur l'ouvrant à l'étape E93.

Dans l'exemple illustré, il ressort clairement de la figure 8a qu'aucun modèle ne ressemble majoritairement aux paramètres caractéristiques p_{c}1 à p_{c}n, en conséquence on passe à l'étape d'inhibition E93. En revanche, sur la figure 8b le modèle M1 est le plus ressemblant, on passe donc à l'étape de vérification E95.

En pratique, un unique modèle peut être mémorisé pour authentifier une commande de l'utilisateur : le modèle se référant à un stimulus provoqué par un doigt ou une main d'un utilisateur mentionné précédemment.

En outre, on peut prévoir, avant d'avoir terminé à l'étape E7 de comparer l'ensemble des paramètres caractéristiques calculés p_{c} avec les paramètres de référence p_{c} correspondants, que lorsqu'un nombre prédéterminé de paramètres caractéristiques p_{c} correspond aux paramètres de référence p_{c} d'un même modèle M, on arrête cette étape de comparaison puisque le signal de sortie s(t) présente une forte probabilité de ressemblance avec ce modèle M.

On peut prévoir encore que le nombre prédéterminé de paramètres caractéristiques calculés p_{c} comporte des paramètres prédéfinis, par exemple ceux correspondants à l'aspect lisse de la courbe ou encore à l'aspect arrondi de certaines portions de la courbe, de manière déterminer plus rapidement à quel modèle M ressemble le signal de sortie s(t).

Ainsi, on authentifie plus rapidement une commande d'un utilisateur par exemple lorsque le signal de sortie s(t) n'est pas bruité par rapport à un signal de sortie bruité. Le déclenchement de l'action sur l'ouvrant, comme le déverrouillage, peut avoir lieu plus vite évitant ainsi à l'utilisateur d'attendre top longtemps avant de pouvoir rentrer dans le véhicule.

On comprend, donc qu'avec un tel procédé de déclenchement d'une action sur l'ouvrant, on distingue de façon fiable une commande volontaire d'un utilisateur pour déclencher une action sur l'ouvrant par rapport à tout autre stimulus, comme la projection d'une masse d'eau pouvant faire varier la capacité de la surface de détection. En outre, un tel procédé évite de confondre deux stimulus provoquant une variation selon un scénario sensiblement identité.

## Revendications

1. Procédé de déclenchement d'une action sur un ouvrant, notamment de véhicule automobile, **caractérisé en ce que** ledit procédé comporte les étapes suivantes :
- on détecte une variation de capacité en fonction du temps sur une surface de détection dudit ouvrant et on délivre un signal de sortie (s(t)) représentatif de ladite variation détectée,
- on décompose le signal de sortie en une pluralité de portions élémentaires de signal (sₑ) sur des périodes de temps prédéfinies,
- pour chaque portion élémentaire de signal (sₑ), on calcule un paramètre caractéristique (p_{c}) de ladite variation détectée,
- on compare lesdits paramètres caractéristiques calculés (p_{c}) avec des paramètres de référence (pᵣ) correspondants d'un nombre prédéterminé (m) de modèles (M) mémorisés,
- on authentifie une commande d'un utilisateur dudit véhicule pour déclencher une action associée sur l'ouvrant en fonction des résultats de la comparaison, et
- on déclenche une action associée sur l'ouvrant lorsqu'une commande dudit utilisateur est authentifiée.

2. Procédé selon la revendication 1, **caractérisé en ce que** l'action déclenchée est le verrouillage ou le déverrouillage de l'ouvrant.

3. Procédé selon l'une des revendications 1 ou 2, **caractérisé en ce qu'**une courbe représentative dudit signal de sortie (s(t)) présente une forme sensiblement en U, et **en ce qu'**on décompose ledit signal de sortie (s(t)) en au moins sept portions élémentaires de signal (sₑ1, sₑ2, sₑ3, sₑ4, Sₑ5, Sₑ6, Sₑ7), dont :
- la première portion (sₑ1) correspond au début de ladite courbe représentative,
- la seconde portion (sₑ2) correspond à la première pente de ladite courbe représentative,
- la troisième portion (sₑ3) correspond à une portion intermédiaire entre la fin de ladite première pente et un début de seuil d'extrémité de ladite courbe représentative,
- la quatrième portion (sₑ4) correspond audit seuil d'extrémité,
- la cinquième portion (sₑ5) correspond à une portion intermédiaire entre la fin dudit seuil d'extrémité et un début d'une seconde pente de ladite courbe représentative,
- la sixième portion (sₑ6) correspond à ladite seconde pente, et
- la septième portion (sₑ7) correspond à la fin de ladite courbe représentative.

4. Procédé selon l'une quelconque des revendications 1 à 3, **caractérisé en ce que** lesdits paramètres caractéristiques (p_{c}) comportent au moins un des paramètres suivants : la vitesse de la variation, la monotonie de la variation, le seuil d'extrémité atteint, la durée du signal de sortie à un même seuil.

5. Procédé selon l'une quelconque des revendications 1 à 4, **caractérisé en ce qu'**au moins un desdits paramètres caractéristiques (p_{c}) correspond à une donnée spécifique de ladite courbe représentative, tel que le rayon de courbure, la pente, l'aspect lisse d'au moins une portion de ladite courbe sur une période de temps prédéfinie.

6. Procédé selon l'une quelconque des revendications 1 à 5, **caractérisé en ce que** l'étape d'authentification d'une commande dudit utilisateur comporte les sous-étapes suivantes :
- pour chaque paramètre caractéristique calculé (p_{c}), on identifie le paramètre de référence (p_{c}) correspondant sensiblement équivalent audit paramètre caractéristique calculé (p_{c}),
- on détecte si un modèle (M) mémorisé comporte une majorité de paramètres de référence (p_{c}) identifiés comme étant sensiblement équivalents auxdits paramètres caractéristiques calculés (p_{c}) correspondants, et
- on vérifie si le modèle (M) détecté se réfère à une commande dudit utilisateur.

7. Procédé selon la revendication 6, **caractérisé en ce qu'**il comprend une étape dans laquelle on vérifie si un nombre prédéterminé de paramètres caractéristiques (p_{c}) sont sensiblement équivalents aux paramètres de référence (p_{c}) d'un même modèle M, et si oui on interrompt la comparaison desdits paramètres caractéristiques calculés (p_{c}) avec lesdits paramètres de référence (p_{c}).

8. Procédé selon la revendication 7, **caractérisé en ce que** le nombre prédéterminé de paramètres caractéristiques (p_{c}) comporte au moins un paramètre caractéristique prédéfini.

9. Dispositif de déclenchement d'une action sur un ouvrant, notamment de véhicule automobile, ledit dispositif comportant un capteur capacitif sur une surface de détection dudit ouvrant pour détecter une variation de capacité sur ladite surface,
**caractérisé en ce que** ledit dispositif comporte en outre :
- au moins une bibliothèque (7) dans laquelle est mémorisé un nombre prédéterminé (m) de modèles (M),
- au moins un moyen de traitement pour :
• détecter une variation de capacité en fonction du temps sur une surface de détection dudit ouvrant et délivrer un signal de sortie (s(t)) représentatif de ladite variation, détectée,
• décomposer le signal de sortie (s(t)) en une pluralité de portions élémentaires de signal (sₑ) sur des périodes de temps prédéfinies,
• pour chaque portion élémentaire de signal (sₑ), calculer un paramètre caractéristique (p_{c}) de ladite variation détectée,
• comparer lesdits paramètres caractéristiques calculés (p_{c}) avec des paramètres de référence (pᵣ) correspondants d'un nombre prédéterminé de modèles (M) mémorisés,
• authentifier une commande d'un utilisateur dudit véhicule pour déclencher une action associée sur l'ouvrant en fonction des résultats de la comparaison, et
• déclencher une action associée sur l'ouvrant lorsqu'une commande dudit utilisateur est authentifiée.

## Claims

1. Method for triggering an action on an opening leaf, notably of a motor vehicle, **characterized in that** the said method comprises the following steps:
- a variation in capacitance as a function of time is detected on a detection surface of the said opening leaf and an output signal (s(t)) indicative of the said detected variation is output,
- the output signal is broken down into a plurality of elementary signal portions (sₑ) over predefined time periods,
- for each elementary signal portion (sₑ), a characteristic parameter (p_{c}) of the said detected variation is calculated,
- the said calculated characteristic parameters (p_{c}) are compared against corresponding reference parameters (pᵣ) of a predetermined number (m) of model/s (M) stored in memory,
- a command by a user of the said vehicle to trigger an associated action on the opening leaf is authenticated on the basis of the results of the comparison, and
- an associated action on the opening leaf is triggered when a command from the said user is authenticated.

2. Method according to Claim 1, **characterized in that** the action triggered is the locking or unlocking of the opening leaf.

3. Method according to either of Claims 1 and 2, **characterized in that** a curve that is representative of the said output signal (s(t)) is substantially U-shaped, and **in that** the said output signal (s(t)) is broken down into at least seven elementary signal portions (sₑ₁, sₑ2, sₑ3, sₑ4, sₑ5, sₑ6, sₑ7), of which:
- the first portion (sₑ1) corresponds to the start of the said representative curve,
- the second portion (sₑ2) corresponds to the first gradient of the said representative curve,
- the third portion (sₑ3) corresponds to a portion somewhere between the end of the said first gradient and a start of the end level portion of the said representative curve,
- the fourth portion (sₑ4) corresponds to the said end level portion,
- the fifth portion (sₑ5) corresponds to a portion somewhere between the end of the said end level portion and the start of a second gradient of the said representative curve,
- the sixth portion (sₑ6) corresponds to the said second gradient, and
- the seventh portion (sₑ7) corresponds to the end of the said representative curve.

4. Method according to any one of Claims 1 to 3, **characterized in that** the said characteristic parameters (p_{c}) comprise at least one of the following parameters: the rate of variation, the monotony of the variation, the end level attained, the time the output signal spends at one and the same level.

5. Method according to any one of Claims 1 to 4, **characterized in that** at least one of the said characteristic parameters (p_{c}) corresponds to a specific piece of data relating to the said representative curve, such as the radius of curvature, the gradient, the smooth appearance of at least one portion of the said curve over a predefined period of time.

6. Method according to any one of Claims 1 to 5, **characterized in that** the step of authenticating a command by the said user comprises the following sub steps:
- for each calculated characteristic parameter (p_{c}), the corresponding reference parameter (pᵣ) substantially equivalent to the said calculated characteristic parameter (p_{c}) is identified.
- a step of detecting whether a model (M) stored in memory comprises a majority of reference parameters (pᵣ) that have been identified as being substantially equivalent to the said corresponding calculated characteristic parameters (p_{c}), and
- a step of checking whether the detected model (M) refers to a command by the said user.

7. Method according to Claim 6, **characterized in that** it comprises a step that involves checking whether a predetermined number of characteristic parameters (p_{c}) are substantially equivalent to the reference parameters (pᵣ) of one and the same model M, and, if they are, the comparison of the said calculated characteristic parameters (p_{c}) against the said reference parameters (pᵣ) is interrupted.

8. Method according to Claim 7, **characterized in that** the predetermined number of characteristic parameters (p_{c}) comprises at least one predefined characteristic parameter.

9. Device for triggering an action on an opening leaf, notably of a motor vehicle, the said device comprising a capacitive sensor on a detection surface of the said opening leaf in order to detect a variation in capacitance on the said surface,
**characterized in that** the said device further comprises:
- at least one library (7) in which a predetermined number (m) of model/s (M) is stored,
- at least one processing means for:
• detecting a variation in capacitance as a function of time on a detection surface of the said opening leaf and outputting an output signal(s(t)) indicative of the said detected variation,
• breaking down the output signal (s(t)) into a plurality of elementary signal portions (sₑ) over predefined time periods,
• for each elementary signal portion (sₑ), calculating a characteristic parameter (p_{c}) of the said detected variation,
• comparing the said calculated characteristic parameters (p_{c}) against corresponding reference parameters (pᵣ) of a predetermined number of model/s (M) stored in memory,
• authenticating a command by a user of the said vehicle in order to trigger an associated action on the opening leaf, on the basis of the results of the comparison, and
• triggering an associated action on the opening leaf when a command from the said user is authenticated.

## Patentansprüche

1. Verfahren zum Auslösen einer Einwirkung auf eine Öffnungseinrichtung, insbesondere eines Kraftfahrzeugs, **dadurch gekennzeichnet, dass** das Verfahren die folgenden Schritte enthält:
- auf einer Erfassungsfläche der Öffnungseinrichtung wird eine zeitabhängige Kapazitätsänderung erfasst und ein Ausgangssignal (s(t)) geliefert, das die erfasste Änderung darstellt,
- das Ausgangssignal wird in mehrere elementare Signalteile (sₑ) über vordefinierte Zeiträume aufgegliedert,
- für jedes elementare Signalteil (sₑ) wird ein kennzeichnender Parameter (p_{c}) der erfassten Änderung berechnet,
- die berechneten kennzeichnenden Parameter (p_{c}) werden mit entsprechenden Bezugsparametern (p_{c}) einer vorbestimmten Anzahl (m) von gespeicherten Modellen (M) verglichen,
- ein Befehl eines Benutzers des Fahrzeugs, um eine zugeordnete Einwirkung auf die Öffnungseinrichtung auszulösen, wird abhängig von den Ergebnissen des Vergleichs authentifiziert, und
- wenn ein Befehl des Benutzers authentifiziert ist, wird eine zugeordnete Einwirkung auf die Öffnungseinrichtung ausgelöst.

2. Verfahren nach Anspruch 1, **dadurch gekennzeichnet, dass** die ausgelöste Einwirkung das Verriegeln oder Entriegeln der Öffnungseinrichtung ist.

3. Verfahren nach einem der Ansprüche 1 oder 2, **dadurch gekennzeichnet, dass** eine für das Ausgangssignal (s(t)) repräsentative Kurve im Wesentlichen eine U-Form aufweist, und dass das Ausgangssignal (s(t)) in mindestens sieben elementare Signalteile (sₑ1, sₑ2, sₑ3, sₑ4, sₑ5, sₑ6, sₑ7) aufgegliedert wird, von denen:
- der erste Teil (sₑ1) dem Beginn der repräsentativen Kurve entspricht,
- der zweite Teil (sₑ2) der ersten Steigung der repräsentativen Kurve entspricht,
- der dritte Teil (sₑ3) einem Zwischenteil zwischen dem Ende der ersten Steigung und einem Endschwellenbeginn der repräsentativen Kurve entspricht,
- der vierte Teil (sₑ4) der Endschwelle entspricht,
- der fünfte Teil (sₑ5) einem Zwischenteil zwischen dem Ende der Endschwelle und einem Beginn einer zweiten Steigung der repräsentativen Kurve entspricht,
- der sechste Teil (sₑ6) der zweiten Steigung entspricht, und
- der siebte Teil (sₑ7) dem Ende der repräsentativen Kurve entspricht.

4. Verfahren nach einem der Ansprüche 1 bis 3, **dadurch gekennzeichnet, dass** die kennzeichnenden Parameter (p_{c}) mindestens einen der folgenden Parameter aufweisen: die Geschwindigkeit der Änderung, die Monotonie der Änderung, die erreichte Endschwelle, die Dauer des Ausgangssignals auf der gleichen Schwelle.

5. Verfahren nach einem der Ansprüche 1 bis 4, **dadurch gekennzeichnet, dass** mindestens einer der kennzeichnenden Parameter (p_{c}) einem spezifischen Datenwert der repräsentativen Kurve entspricht, wie dem Krümmungsradius, der Steigung, dem glatten Aussehen mindestens eines Teils der Kurve über einen vordefinierten Zeitraum.

6. Verfahren nach einem der Ansprüche 1 bis 5, **dadurch gekennzeichnet, dass** der Schritt der Authentifizierung eines Befehls des Benutzers die folgenden Teilschritte aufweist:
- für jeden berechneten kennzeichnenden Parameter (p_{c}) wird der entsprechende Bezugsparameter (pᵣ) identifiziert, der im Wesentlichen dem berechneten kennzeichnenden Parameter (p_{c}) gleichwertig ist,
- es wird erfasst, ob ein gespeichertes Modell (M) eine Mehrheit von Bezugsparametern (pᵣ) aufweist, die als den entsprechenden berechneten kennzeichnenden Parametern (p_{c}) im Wesentlichen gleichwertig identifiziert werden; und
- es wird geprüft, ob das erfasste Modell (M) sich auf einen Befehl des Benutzers bezieht.

7. Verfahren nach Anspruch 6, **dadurch gekennzeichnet, dass** es einen Schritt enthält, in dem geprüft wird, ob eine vorbestimmte Anzahl von kennzeichnenden Parametern (p_{c}) den Bezugsparametern (p_{c}) eines gleichen Modells M im Wesentlichen gleichwertig sind, und wenn ja, der Vergleich der berechneten kennzeichnenden Parameter (p_{c}) mit den Bezugsparametern (pᵣ) unterbrochen wird.

8. Verfahren nach Anspruch 7, **dadurch gekennzeichnet, dass** die vorbestimmte Anzahl von kennzeichnenden Parametern (p_{c}) mindestens einen vordefinierten kennzeichnenden Parameter aufweist.

9. Vorrichtung zum Auslösen einer Einwirkung auf eine Öffnungseinrichtung, insbesondere eines Kraftfahrzeugs; wobei die Vorrichtung einen kapazitiven Sensor auf einer Erfassungsfläche der Öffnungseinrichtung aufweist, um eine Kapazitätsänderung auf der Fläche zu erfassen, **dadurch gekennzeichnet, dass** die Vorrichtung außerdem aufweist:
- mindestens eine Bibliothek (7), in der eine vorbestimmte Anzahl (m) von Modellen (M) gespeichert ist;
- mindestens eine Verarbeitungseinrichtung, um:
• eine zeitabhängige Kapazitätsänderung auf einer Erfassungsfläche der Öffnungseinrichtung zu erfassen und ein für die erfasste Änderung repräsentatives Ausgangssignal (s(t)) zu liefern,
• das Ausgangssignal (s(t)) in eine Vielzahl von elementaren Signalteilen (sₑ) über vordefinierte Zeiträume zu zergliedern;
• für jedes elementare Signalteil (sₑ) einen kennzeichnenden Parameter (p_{c}) der erfassten Änderung zu berechnen,
• die berechneten kennzeichnenden Parameter (p_{c}) mit entsprechenden Bezugsparametern (pᵣ) einer vorbestimmten Anzahl von gespeicherten Modellen (M) zu vergleichen,
• eine Befehl eines Benutzers des Fahrzeugs zu authentifizieren, um eine zugeordnete Einwirkung auf die Öffnungseinrichtung abhängig von den Ergebnissen des Vergleichs auszulösen, und
• eine zugeordnete Einwirkung auf die Öffnungseinrichtung auszulösen, wenn ein Befehl des Benutzers authentifiziert wird.
